# EUROPÄISCHE PATENTSCHRIFT

(11) **EP 2 337 169 B1**
(45) Veröffentlichungstag und Bekanntmachung des Hinweises auf die Patenterteilung: **22.03.2017**
(21) Anmeldenummer: 11161727.0
(22) Anmeldetag: 28.08.2008
(51) Int. Cl.: H01S 5/16, H01S 5/10, H01S 5/12, H01S 5/20, H01S 5/042

(54) **Kantenemittierender Halbleiterlaser mit einem Wellenleiter**
Edge emitting semiconductor laser with a waveguide
Laser semi-conducteur à émission latérale avec un guide d'ondes

(30) Priorität: 28.09.2007 DE 102007046722; 07.12.2007 DE 102007058950
(43) Veröffentlichungstag der Anmeldung: 22.06.2011
(62) Teilanmeldung aus: 08015212.7
(73) Patentinhaber: OSRAM Opto Semiconductors GmbH, 93055 Regensburg (DE)
(72) Erfinder: Schmid, Wolfgang, 93053, Regensburg (DE)
(74) Vertreter: Epping - Hermann - Fischer

(56) Entgegenhaltungen:
- US-A- 5 528 616
- US-A1- 2004 047 378
- KATSUYUKI UTAKA, KATSUMI KISHINO, YASUHARU SUEMATSU: "Twin-Guide Laser with Narrow Radiation Angle", JAPAN JOURN. APPL. PHYS., Bd. 17, Nr. 4, 1. April 1978 (1978-04-01), Seiten 751-752, XP1662016,
- KATSUYUKI UTAKA, YASUHARU SUEMATSU, KATSUMI KISHINO AND HIDEO KAWANISHI: "Measurement of Coupling Coefficient and Coupling Length of GaAs/AlGaAs Integrated Twin-Guide Injection Lasers Prepared by Liquid-Phase Epitaxy", TRANSACTION OF THE IECE, Bd. E62, Nr. 5, 1. Mai 1979 (1979-05-01), Seiten 319-323, XP1662008,
- AMANN M C: "WIDELY TUNABLE DISTRIBUTED FORWARD COUPLED (DFC) LASER", ELECTRONICS LETTERS, IEE STEVENAGE, GB, vol. 29, no. 9, 29 April 1993 (1993-04-29) , pages 793-794, XP000351865, ISSN: 0013-5194

## Beschreibung

Kantenemittierender Halbleiterlaser mit einem Wellenleiter Die Erfindung betrifft einen kantenemittierenden Halbleiterlaser gemäß dem Oberbegriff des Patentanspruchs 1. Diese Patentanmeldung beansprucht die Priorität der deutschen Patentanmeldungen 10 2007 046 722.4 und 10 2007 058 950.8.

Bei kantenemittierenden Halbleiterlasern treten an den Oberflächen der Seitenfacetten, die die Laserspiegel des kantenemittierenden Halbleiterlasers ausbilden, mit einer erhöhten Wahrscheinlichkeit nicht-strahlende Rekombinationen auf, das heißt Ladungsträger rekombinieren im Bereich der Seitenfacetten verstärkt unter der Erzeugung von Wärme. Die dadurch auftretende Ladungsträgerverarmung wird durch Absorption von Laserstrahlung ausgeglichen. Da die Wärmeerzeugung an der Seitenfacette stärker ist als im Inneren des Halbleiterkörpers, ist der Halbleiter hier wärmer, wodurch sich die Bandlücke des Halbleitermaterials vermindert. Dadurch werden nicht-strahlende Rekombinationen weiter begünstigt, was zu einer weiteren Erhöhung der Wärmeentwicklung führen kann. Bei vergleichsweise hohen Laserintensitäten kann ein instabiler Kreislauf entstehen, der bis zur Aufschmelzung der Seitenfacette führen kann. Dieser mögliche Zerstörungsmechanismus ist insbesondere für die aktive Schicht kritisch, da die benachbarten Schichten in der Regel eine größere Bandlücke aufweisen und damit für die Laserstrahlung im Wesentlichen transparent sind.

Aus der Druckschrift EP 0 416 190 A1 ist bekannt, die Seitenfacetten des Halbleiterlasers mit einer Passivierungsschicht zu versehen.

In der Druckschrift US 6,323,052 B1 wird beschrieben, die Seitenfacetten des Halbleiterlasers mit einem Sputterprozess zu behandeln, um dort Oxide zu beseitigen, die zu nichtstrahlenden Rekombinationen führen könnten.

In der Druckschrift US 5,171,707 wird ein Verfahren beschrieben, mit dem im Bereich der Seitenfacetten eines kantenemittierenden Halbleiterlasers durch diffusionsinduzierte Durchmischung transparente Bereiche erzeugt werden, die die von der aktiven Schicht erzeugte Strahlung nicht absorbieren. Ein ähnliches Verfahren ist auch aus der Druckschrift WO 96/11503 A2 bekannt.

In der Druckschrift M.-C. Amann, B. Borchert, S. Illek, T. Wolf: "WIDELY TUNABLE DISTRIBUTED FORWARD COUPLED (DFC) LASER", Electronics Letters, Bd. 29, Nr. 9 (1983), S. 793-794 wird ein kantenemittierender Halbleiterlaser mit gekoppelten Wellenleitern beschrieben, bei dem mit periodisch angeordneten Kontaktflächen Ladungsträger zur Veränderung des Brechungsindex injiziert werden.

Der Erfindung liegt die Aufgabe zugrunde, einen verbesserten kantenemittierenden Halbleiterlaser anzugeben, bei dem die Wärmeerzeugung in der aktiven Schicht durch nicht-strahlende Rekombinationen an der Seitenfacette des Halbleiterlasers vermindert ist.

Diese Aufgabe wird durch einen kantenemittierenden Halbleiterlaser mit den Merkmalen des Patentanspruchs 1 gelöst. Vorteilhafte Ausgestaltungen und Weiterbildungen der Erfindung sind Gegenstand der abhängigen Ansprüche.

Bei einem kantenemittierenden Halbleiterlaser mit einer Laserstrahlung erzeugenden aktiven Schicht, die in eine erste Wellenleiterschicht eingebettet ist, wobei die erste Wellenleiterschicht zwischen einer ersten Mantelschicht und einer zweiten Mantelschicht angeordnet ist und in lateraler Richtung an Seitenfacetten des Halbleiterlasers angrenzt, grenzt an die zweite Mantelschicht eine zweite Wellenleiterschicht an, in die keine aktive Schicht eingebettet ist. Die erste Wellenleiterschicht und die zweite Wellenleiterschicht sind in ihrer gesamten lateralen Ausdehnung zwischen den Seitenfacetten optisch aneinander gekoppelt. An einer von der ersten Wellenleiterschicht abgewandten Seite der zweiten Wellenleiterschicht ist eine dritte Mantelschicht angeordnet.

Der kantenemittierende Halbleiterlaser enthält also einen aktiven Wellenleiter, der aus der ersten Wellenleiterschicht mit der darin eingebetteten aktiven Schicht gebildet wird, und einen optisch an den ersten Wellenleiter gekoppelten passiven Wellenleiter, der durch die zweite Wellenleiterschicht gebildet wird, die keine aktive Schicht enthält. Darunter, dass die zweite Wellenleiterschicht optisch an die erste Wellenleiterschicht gekoppelt ist, wird im Rahmen dieser Anmeldung verstanden, dass die in der aktiven Schicht erzeugte Laserstrahlung zumindest teilweise aus dem ersten Wellenleiter in den zweiten Wellenleiter überkoppeln kann. Die in der aktiven Schicht des kantenemittierenden Halbleiterlasers erzeugte Laserstrahlung breitet sich daher nicht nur in der ersten Wellenleiterschicht, in die die aktive Schicht eingebettet ist, aus, sondern zumindest in Teilbereichen des Halbleiterlasers auch in der zweiten Wellenleiterschicht.

Bevorzugt sind die erste Wellenleiterschicht und die zweite Wellenleiterschicht derart optisch aneinander gekoppelt, dass sich an den Seitenfacetten des Halbleiterlasers zumindest ein Teil der in der aktiven Schicht erzeugten Laserstrahlung in der zweiten Wellenleiterschicht ausbreitet. Auf diese Weise wird vorteilhaft erreicht, dass die Intensität der Laserstrahlung in der aktiven Schicht an den Seitenfacetten geringer ist als bei einem herkömmlichen kantenemittierenden Halbleiterlaser, der keinen optisch an den ersten Wellenleiter gekoppelten zweiten Wellenleiter enthält. Nicht-strahlende Rekombinationen von Ladungsträgern und die damit verbundene Wärmeentwicklung an der Seitenfacette des Halbleiterlasers im Bereich der aktiven Schicht werden auf diese Weise vermindert. Die zweite Wellenleiterschicht weist vorzugsweise eine größere elektronische Bandlücke auf als die aktive Schicht, so dass die zweite Wellenleiterschicht für die Laserstrahlung im Wesentlichen transparent ist und somit nicht die in der Einleitung beschriebene Problematik der Absorption von Laserstrahlung aufgrund einer Ladungsträgerverarmung an der Seitenfacette aufweist. Das Risiko einer Schädigung des Bauelements durch eine hohe Intensität der Laserstrahlung an der Seitenfacette ist also im Bereich der zweiten Wellenleiterschicht geringer als im Bereich der ersten Wellenleiterschicht, die die aktive Schicht enthält.

Bevorzugt ist die zweite Wellenleiterschicht derart an die erste Wellenleiterschicht optisch gekoppelt, dass die sich in der ersten Wellenleiterschicht ausbreitende Laserstrahlung an den Seitenfacetten des Halbleiterlasers ein Intensitätsminimum aufweist.

Die Erfindung macht sich die Erkenntnis zu Nutze, dass elektromagnetische Strahlung, die sich in benachbarten Wellenleiterschichten ausbreitet, zumindest teilweise von dem einen Wellenleiter in den anderen Wellenleiter überkoppeln kann. Es ist sogar eine vollständige Überkopplung der Strahlung möglich, falls sich die elektromagnetischen Wellen in beiden Wellenleitern gleich schnell ausbreiten.

Die Grundlagen der optischen Kopplung zweier Wellenleiter sind an sich aus der integrierten Optoelektronik bekannt. Die Stärke der Kopplung zweier Wellenleiter wird durch den Koppelfaktor κ = π/2L_{C} beschrieben, wobei L_{C} die Transferlänge ist, die die Länge der Kopplungsstrecke angibt, in der die maximal mögliche Überkopplung der Strahlung aus dem ersten Wellenleiter in den zweiten Wellenleiter erfolgt. Für den Fall einer vollständigen Überkopplung gibt die Transferlänge also die Länge der Kopplungsstrecke an, in der die Strahlung vollständig aus dem ersten Wellenleiter in den zweiten Wellenleiter überkoppelt. Eine vollständige Überkopplung findet statt, wenn die Phasenabweichung δ = Δn π/λ = 0 wird, wobei λ die Wellenlänge der Strahlung und Δn die Brechungsindexdifferenz zwischen den Wellenleitern ist. Das örtliche Verhalten der Wellen in gekoppelten Wellenleitern verhält sich ähnlich wie das zeitliche Verhalten von Schwingungen bei einem gekoppelten Pendel. Eine Phasenabweichung δ ≠ 0 entspricht dem Fall einer unterschiedlichen Eigenfrequenz der einzelnen Pendel, in dem kein vollständiger Energietransfer möglich wäre.

Im vorliegenden Fall der optisch gekoppelten Wellenleiterschichten kann die Phasenabweichung δ und damit die Stärke der optischen Kopplung insbesondere durch die Wahl der Dicke und des Brechungsindex der zwischen den Wellenleiterschichten angeordneten zweiten Mantelschicht sowie durch die effektiven Brechungsindizes der beiden Wellenleiterschichten eingestellt werden. Beispielsweise kann die zweite Mantelschicht in lateraler Richtung eine konstante Dicke und einen konstanten Brechungsindex aufweisen, wobei die Stärke der Kopplung zwischen der ersten Wellenleiterschicht und der zweiten Wellenleiterschicht durch eine lokale Variation des effektiven Brechungsindex einer der beiden Wellenleiterschichten räumlich verändert wird.

Unter dem effektiven Brechungsindex n_{eff} einer Wellenleiterschicht wird hier und im Folgenden der Brechungsindex verstanden, der das Verhältnis der Wellenzahl k_{eff} bei der Ausbreitung in der Wellenleiterschicht im Vergleich zum Vakuum angibt, es ist also k_{eff}= n_{eff} 2π/λ. Der effektive Brechungsindex kann von dem Brechungsindex des Halbleitermaterials der Wellenleiterschicht abweichen, weil die Laserstrahlung bei der Ausbreitung in der Wellenleiterschicht teilweise in die benachbarten Mantelschichten eindringen kann.

Bei dem kantenemittierenden Halbleiterlaser sind die erste Wellenleiterschicht und die zweite Wellenleiterschicht in ihrer gesamten lateralen Ausdehnung optisch gekoppelt. Dazu sind vorteilhaft die Dicke und der Brechungsindex der zwischen der ersten Wellenleiterschicht und der zweiten Wellenleiterschicht angeordneten zweiten Mantelschicht sowie die effektiven Brechungsindizes der ersten Wellenleiterschicht und der zweiten Wellenleiterschicht derart aneinander angepasst, dass die in der aktiven Schicht erzeugte Laserstrahlung über die gesamte Breite des Halbleiterlasers von der ersten Wellenleiterschicht in die zweite Wellenleiterschicht und umgekehrt überkoppeln kann.

Die in der aktiven Schicht erzeugte Laserstrahlung bildet in dem durch die Seitenfacetten des Halbleiterlasers gebildeten Resonator eine stehende Welle aus, die in lateraler Richtung in periodisch angeordneten Abständen jeweils Intensitätsmaxima in der ersten Wellenleiterschicht und korrespondierende Intensitätsminima in der zweiten Wellenleiterschicht sowie Intensitätsminima in der ersten Wellenleiterschicht und korrespondierende Intensitätsmaxima in der zweiten Wellenleiterschicht aufweist. In dem Halbleiterlaser gibt es also periodisch angeordnete Bereiche, in denen die sich entlang der Wellenleiterschichten ausbreitende Laserstrahlung eine hohe Intensität in der ersten Wellenleiterschicht und eine niedrige Intensität in der zweiten Wellenleiterschicht aufweist, und dazwischen angeordnete Bereiche, in denen die Laserstrahlung eine hohe Intensität in der zweiten Wellenleiterschicht und eine niedrige Intensität in der ersten Wellenleiterschicht aufweist.

Vorzugsweise weist die stehende Welle an den Seitenfacetten des Halbleiterlasers jeweils ein Intensitätsminimum in der ersten Wellenleiterschicht auf. Dies bedeutet, dass sich die Laserstrahlung im Bereich der Seitenfacette im Wesentlichen oder vorzugsweise vollständig in der zweiten Wellenleiterschicht ausbreitet, so dass die Laserstrahlung an der Seitenfacette des Halbleiterlasers in der aktiven Schicht nur eine geringe oder vorzugsweise gar keine Intensität aufweist.

Zum elektrischen Pumpen der aktiven Schicht des Halbleiterlasers sind mehrere Kontaktflächen in periodischer Abfolge auf Teilbereiche des Halbleiterlasers aufgebracht. Dabei entspricht der Abstand der Kontaktflächen vorteilhaft der zweifachen Transferlänge, wobei die Transferlänge der Abstand zwischen einem Intensitätsmaximum und einem benachbarten Intensitätsminimum innerhalb einer der Wellenleiterschichten ist. Die Transferlänge gibt also den Abstand an, in dem eine maximale Überkopplung der Laserstrahlung von der ersten Wellenleiterschicht zur zweiten Wellenleiterschicht auftritt. Die zweifache Transferlänge ist demnach der Abstand zwischen zwei benachbarten Intensitätsmaxima in der ersten Wellenleiterschicht oder der zweiten Wellenleiterschicht. Dadurch, dass die Kontaktflächen den Abstand der zweifachen Transferlänge aufweisen, werden in der aktiven Schicht gezielt zwei benachbarte Intensitätsmaxima durch elektrisches Pumpen angeregt. Unter dem Abstand der Kontaktflächen wird hierbei der Abstand der Mittelpunkte der Kontaktflächen verstanden. Dabei ist es vorteilhaft, wenn Kontaktflächen, die den Seitenfacetten des Halbleiterlasers benachbart sind, in einem Abstand von der Seitenfacette des Halbleiterlasers angeordnet sind, der gleich der Transferlänge L_{C} oder einem ungeradzahligen Vielfachen der Transferlänge L_{C} ist. Dabei ist unter dem Abstand der Kontaktfläche von der Seitenfläche der Abstand des Mittelpunkts der Kontaktfläche von der Seitenfläche zu verstehen. Auf diese Weise wird erreicht, dass Teilbereiche der aktiven Schicht elektrisch gepumpt werden, die um eine Transferlänge oder um ein ungeradzahliges Vielfaches der Transferlänge von der Seitenfacette beabstandet sind. Die sich aus diesen elektrisch gepumpten Teilbereichen in Richtung der Seitenfacetten ausbreitende Laserstrahlung kann innerhalb der Transferlänge maximal und vorzugsweise nahezu vollständig in die zweite Wellenleiterschicht überkoppeln, so dass an den Seitenfacetten des Halbleiterlasers jeweils ein Intensitätsminimum in der aktiven Schicht und ein Intensitätsmaximum in der zweiten Wellenleiterschicht vorliegt.

Die Erfindung wird im Folgenden anhand von zwei Vergleichsbeispielen und einem Ausführungsbeispiel der Erfindung im Zusammenhang mit den Figuren 1 bis 3 näher erläutert.

Es zeigen:
- Figur 1: eine schematische Darstellung eines Querschnitts durch ein Vergleichsbeispiel eines kantenemittierenden Halbleiterlasers,
- Figur 2: eine schematische Darstellung eines Querschnitts durch ein zweites Vergleichsbeispiel eines kantenemittierenden Halbleiterlasers, und
- Figur 3: eine schematische Darstellung eines Querschnitts durch ein Ausführungsbeispiel eines kantenemittierenden Halbleiterlasers gemäß der Erfindung.

Gleiche oder gleichwirkende Elemente sind in den Figuren mit den gleichen Bezugszeichen versehen. Die Figuren sind nicht als maßstabsgerecht anzusehen, vielmehr können einzelne Elemente zur Verdeutlichung übertrieben groß dargestellt sein.

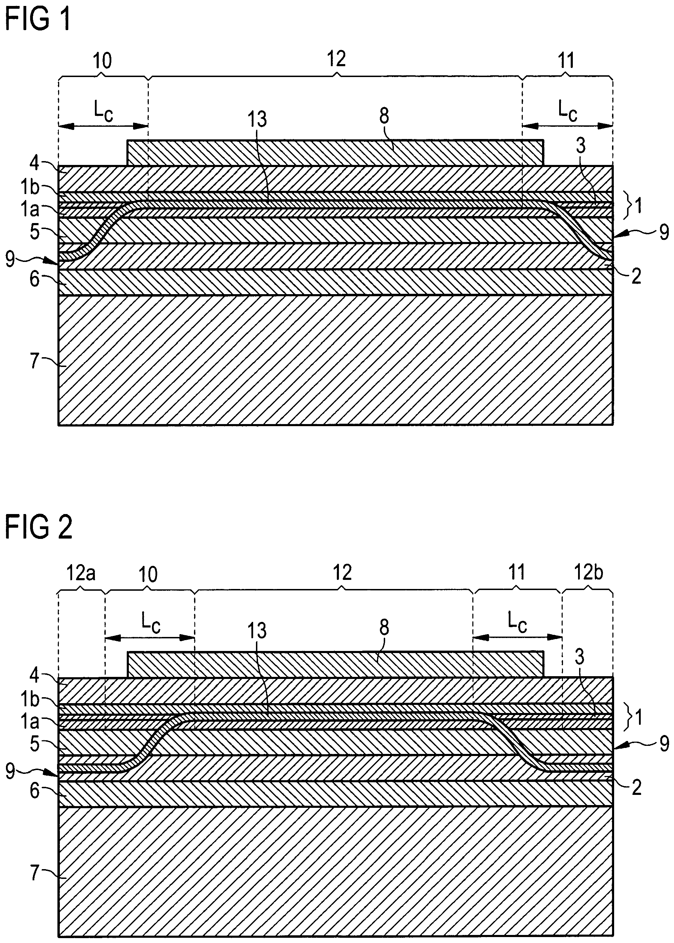

Der in Figur 1 dargestellte kantenemittierende Halbleiterlaser umfasst eine Halbleiterschichtenfolge, die eine erste Wellenleiterschicht 1 enthält, in die eine aktive Schicht 3 eingebettet ist. Die erste Wellenleiterschicht 1 ist aus einer ersten Teilschicht 1a und einer zweiten Teilschicht 1b zusammengesetzt, zwischen denen die aktive Schicht 3 angeordnet ist. Die erste Wellenleiterschicht 1 ist zwischen einer ersten Mantelschicht 4 und einer zweiten Mantelschicht 5 angeordnet. An die zweite Mantelschicht 5 grenzt eine zweite Wellenleiterschicht 2 an, in die keine aktive Schicht eingebettet ist. Weiterhin ist an einer von der ersten Wellenleiterschicht 1 abgewandten Seite der zweiten Wellenleiterschicht 2 eine dritte Mantelschicht 6 angeordnet. Die Halbleiterschichtenfolge ist beispielsweise auf ein Substrat 7 aufgewachsen.

Zur elektrischen Kontaktierung des Halbleiterlasers ist auf eine von dem Substrat 7 abgewandte Seite der Halbleiterschichtenfolge eine Kontaktfläche 8 aufgebracht, bei der es sich beispielsweise um eine Kontaktmetallisierung handeln kann. In lateraler Richtung wird die Halbleiterschichtenfolge, insbesondere die darin enthaltene erste Wellenleiterschicht mit der darin eingebetteten aktiven Schicht 3, durch Seitenfacetten 9 des Halbleiterlasers begrenzt. Die Seitenfacetten 9 des Halbleiterlasers können insbesondere mittels Durchtrennen des Halbleitermaterials erzeugt sein.

Die erste Wellenleiterschicht 1 und die zweite Wellenleiterschicht 2 sind in Teilbereichen 10, 11 optisch aneinander gekoppelt. Dies bedeutet, dass in der aktiven Schicht 3 erzeugte Laserstrahlung in den Teilbereichen 10, 11 aus der ersten Wellenleiterschicht 1 in die zweite Wellenleiterschicht 2 überkoppeln kann.

Die Stärke der optischen Kopplung, die den Anteil der Laserstrahlung 13 bestimmt, die aus der ersten Wellenleiterschicht 1 in die zweite Wellenleiterschicht 2 überkoppeln kann, hängt insbesondere von der Differenz der effektiven Brechungsindizes n₁ der ersten Wellenleiterschicht 1 und n₂ der zweiten Wellenleiterschicht 2 ab. Weiterhin hängt die Stärke der optischen Kopplung der ersten Wellenleiterschicht 1 an die zweite Wellenleiterschicht 2 von der Dicke und dem Brechungsindex der zwischen der ersten Wellenleiterschicht 1 und der zweiten Wellenleiterschicht 2 angeordneten zweiten Mantelschicht 5 ab.

Beispielsweise sind in dem zentralen Bereich 12 des Halbleiterlasers die effektiven Brechungsindizes der ersten Wellenleiterschicht 1 und der zweiten Wellenleiterschicht 2 derart voneinander verschieden, dass die in der ersten Wellenleiterschicht 1 erzeugte Laserstrahlung 13 nicht in die zweite Wellenleiterschicht 2 überkoppeln kann. In diesem Bereich des Halbleiterlasers breitet sich die Laserstrahlung 13 also nur innerhalb der ersten Wellenleiterschicht 1 aus.

In den an die Seitenfacetten 9 angrenzenden Teilbereichen 10, 11 sind die effektiven Brechungsindizes der ersten Wellenleiterschicht 1 und der zweiten Wellenleiterschicht 2 dagegen derart aneinander angepasst, dass die Laserstrahlung 13 in die zweite Wellenleiterschicht 2 überkoppeln kann. Die Wellenleiterschicht 1 weist dazu in den Teilbereichen 10, 11 einen anderen effektiven Brechungsindex auf als in dem zentralen Bereich 12.

Die Änderung des effektiven Brechungsindex der ersten Wellenleiterschicht 1 in den Teilbereichen 10, 11 kann bei der Herstellung des Halbleiterlasers dadurch erfolgen, dass nach dem Aufwachsen der ersten Wellenleiterschicht 1 in den Teilbereichen 10, 11 die Dotierstoffkonzentration erhöht oder ein weiterer Dotierstoff zugefügt wird. Dazu wird beispielsweise auf den zentralen Bereich 12 eine Maske aufgebracht und der zusätzliche Dotierstoff in die Teilbereiche 10, 11 implantiert oder eindiffundiert. Eine andere Möglichkeit zur lokalen Änderung des effektiven Brechungsindex in den Teilbereichen 10, 11 der ersten Wellenleiterschicht 1 besteht darin, dass diese Teilbereiche der ersten Wellenleiterschicht 1 bei der Herstellung des Halbleiterlasers oxidiert werden, zum Beispiel durch eine feuchtthermische Oxidation.

Bevorzugt ist die zweite Wellenleiterschicht 2 derart an die erste Wellenleiterschicht 1 optisch gekoppelt, dass die sich in der ersten Wellenleiterschicht 1 ausbreitende Laserstrahlung 13 an den Seitenfacetten 9 des Halbleiterlasers ein Intensitätsminimum aufweist. Die Breiten des ersten Teilbereichs 10 und des zweiten Teilbereichs 11 werden dazu so gewählt, dass sie gleich der Transferlänge L_{C} sind, wobei die Transferlänge L_{C} die Strecke ist, in der eine maximale Überkopplung der Laserstrahlung 13 von der ersten Wellenleiterschicht 1 zur zweiten Wellenleiterschicht 2 auftritt. Wenn die Breiten des ersten Teilbereichs 10 und des zweiten Teilbereichs 11 geringer als die Transferlänge L_{C} sind, wird nur ein geringerer Teil als der maximal mögliche Teil der Laserstrahlung 13 aus der ersten Wellenleiterschicht 1 in die zweite Wellenleiterschicht 2 übergekoppelt. Wenn die Breiten der Teilbereiche 10, 11 größer sind als die Transferlänge L_{C}, würde die Laserstrahlung 13 ausgehend von dem zentralen Bereich 12 bei ihrer Ausbreitung in Richtung der Seitenfacetten 9 zunächst maximal von der ersten Wellenleiterschicht 1 zur zweiten Wellenleiterschicht 2 überkoppeln und in dem Bereich der Strecke, die über die Transferlänge L_{C} hinausgeht, wieder teilweise in die erste Wellenleiterschicht 1 überkoppeln. Die erwünschte Minimierung der Intensität der Laserstrahlung 13 im Bereich der aktiven Schicht 3 an der Seitenfacette 9 tritt also genau dann ein, wenn die Breiten der Teilbereiche 10, 11 gleich der Transferlänge L_{C} sind.

Die Breite der Teilbereiche 10, 11 kann beispielsweise dadurch an die Transferlänge L_{C} angepasst werden, dass zunächst Teilbereiche 10, 11 mit verändertem effektiven Brechungsindex in der ersten Wellenleiterschicht erzeugt werden, die eine größere Breite als die Transferlänge L_{C} aufweisen, und anschließend die Laserfacetten 9 durch Durchtrennen des Halbleitermaterials in einer Richtung senkrecht zu den Schichtebenen derart erzeugt werden, dass die Breiten der Teilbereiche 10, 11 der Transferlänge L_{C} entsprechen.

Die Kontaktfläche 8, beispielsweise eine Kontaktmetallisierung, ist vorzugsweise auf einen Teilbereich der Oberfläche des Halbleiterlasers aufgebracht, der im Wesentlichen mit der Breite des zentralen Bereichs 12 übereinstimmt, in dem die erste Wellenleiterschicht 1 und die zweite Wellenleiterschicht 2 optisch nicht aneinander gekoppelt sind. Auf diese Weise wird die Laseremission in der aktiven Schicht 3 vorteilhaft in dem Teilbereich 12 des Halbleiterlasers durch elektrisches Pumpen angeregt, in dem eine maximale Intensität in der Wellenleiterschicht 1 erwünscht ist. In den Teilbereichen 10, 11, in denen die Laserstrahlung 13 in die zweite Wellenleiterschicht 2 überkoppelt, wird in der ersten Wellenleiterschicht 1 vorzugsweise keine Laseremission durch elektrisches Pumpen angeregt.

Das in Figur 2 dargestellte zweite Vergleichsbeispiel entspricht im Wesentlichen dem ersten Vergleichsbeispiel, wobei es sich aber dadurch von dem ersten Vergleichsbeispiel unterscheidet, dass die Teilbereiche 10, 11 der ersten Wellenleiterschicht 1, in denen die erste Wellenleiterschicht 1 und die zweite Wellenleiterschicht 2 optisch aneinander gekoppelt sind, nicht unmittelbar an die Seitenfacetten 9 des Halbleiterlasers angrenzen, sondern in einem Abstand von einer Seitenfacette 9 des Halbleiterlasers angeordnet sind.

Der Halbleiterlaser weist also einen zentralen Bereich 12 auf, in dem keine optische Kopplung der ersten Wellenleiterschicht 1 und der zweiten Wellenleiterschicht 2 vorliegt. Nach außen, das heißt in Richtung der Seitenfacetten, grenzen an den zentralen Bereich 12 Teilbereiche 10, 11 an, in denen eine optische Kopplung der ersten Wellenleiterschicht 1 und der zweiten Wellenleiterschicht 2 vorliegt. Weiter nach außen grenzen an die Teilbereiche 10, 11 Teilbereiche 12a, 12b an, in denen wiederum keine optische Kopplung der ersten Wellenleiterschicht 1 an die zweite Wellenleiterschicht 2 vorliegt. Die Teilbereiche 12a, 12b erstrecken sich bis zu den Seitenfacetten 9 des Halbleiterlasers.

Wie bei dem ersten Vergleichsbeispiel sind die Breiten der Teilbereiche 10, 11 vorteilhaft gleich der Transferlänge L_{C}, so dass die in der aktiven Schicht 3 erzeugte Laserstrahlung 13 in den Teilbereichen 10, 11 maximal aus der ersten Wellenleiterschicht 1 in die zweite Wellenleiterschicht 2 überkoppeln kann. In den sich nach außen anschließenden Teilbereichen 12a, 12b, in denen keine optische Kopplung der ersten Wellenleiterschicht 1 und der zweiten Wellenleiterschicht 2 vorliegt, wird die Laserstrahlung in der zweiten Wellenleiterschicht 2 geführt, ohne in die erste Wellenleiterschicht zurückzukoppeln. Auf diese Weise wird vorteilhaft erreicht, dass an den Seitenfacetten 9 des Halbleiterlasers im Bereich der aktiven Schicht 3 ein Intensitätsminimum der Laserstrahlung vorliegt, während sie im Bereich der zweiten Wellenleiterschicht an der Seitenfacette 9 des Halbleiterlasers eine maximale Intensität aufweist. Die Herstellung der Teilbereiche 10, 11, in denen der effektive Brechungsindex der ersten Wellenleiterschicht 1 an den effektiven Brechungsindex der zweiten Wellenleiterschicht 2 angepasst ist, kann wie bei dem ersten Ausführungsbeispiel beispielsweise durch eine lokale Veränderung der Dotierung oder durch eine Oxidation der Teilbereiche 10, 11 erfolgen.

Im Gegensatz zum ersten Vergleichsbeispiel können vorteilhaft sowohl die innere Begrenzung als auch die äußere Begrenzung der Teilbereiche 10, 11 vergleichsweise genau durch fototechnische Verfahren, insbesondere durch Aufbringen einer Maskenschicht auf die seitlich angrenzenden Bereiche 12, 12a 12b des Halbleiterkörpers, definiert werden. Möglicherweise auftretende Toleranzen bei der Positionierung der Trennschnitte zur Erzeugung der Seitenfacetten 9 des Halbleiterlasers wirken sich im Gegensatz zum ersten Vergleichsbeispiel nicht auf die Breite der Teilbereiche 10, 11 aus, in denen die optische Kopplung der ersten Wellenleiterschicht 1 an die zweite Wellenleiterschicht 2 erfolgt. Dies hat den Vorteil, dass die Breiten der Teilbereiche 10, 11 vergleichsweise genau an die Transferlänge L_{C} angepasst werden können.

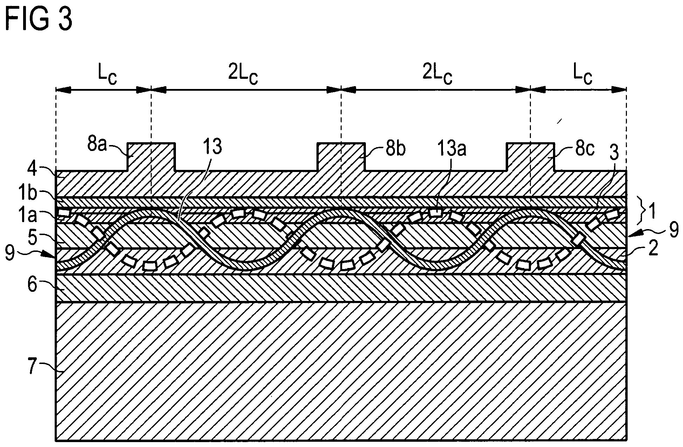

Das in Figur 3 dargestellte Ausführungsbeispiel eines kantenemittieren Halbleiterlasers gemäß der Erfindung unterscheidet sich von den zuvor beschriebenen Vergleichsbeispielen dadurch, dass die erste Wellenleiterschicht 1 und die zweite Wellenleiterschicht 2 in ihrer gesamten lateralen Ausdehnung optisch aneinander gekoppelt sind. In diesem Fall sind also die effektiven Brechungsindizes der ersten Wellenleiterschicht 1 und der zweiten Wellenleiterschicht 2 derart aneinander angepasst, dass in der gesamten Breite des Halbleiterlasers die in der aktiven Schicht 3 erzeugte Laserstrahlung 13 aus der ersten Wellenleiterschicht 1 in die zweite Wellenleiterschicht 2 und umgekehrt überkoppeln kann.

Die Laserstrahlung 13 bildet in dem durch die Laserfacetten 9 gebildeten Resonator eine stehende Welle aus, so dass in der ersten Wellenleiterschicht 1 und der zweiten Wellenleiterschicht 2 jeweils periodisch angeordnete Intensitätsminima und Intensitätsmaxima auftreten. In den Wellenleiterschichten 1, 2 sind die Intensitätsmaxima und Intensitätsminima jeweils um die Transferlänge L_{C} voneinander beabstandet. An den Stellen, an denen die Laserstrahlung 13 in der ersten Wellenleiterschicht 1 ein Intensitätsmaximum aufweist, weist sie in der zweiten Wellenleiterschicht 2 ein korrespondierendes Intensitätsminimum auf und umgekehrt.

Bevorzugt weist die Laserstrahlung 13 an den Seitenfacetten 9 des Halbleiterlasers jeweils ein Intensitätsminimum in der ersten Wellenleiterschicht 1 auf, die die aktive Schicht 3 enthält. An der Seitenfacette 9 des Halbleiterlasers ist also die Intensität der Laserstrahlung 13 in der ersten Wellenleiterschicht 1 minimal und in der zweiten Wellenleiterschicht 2 maximal.

Zum elektrischen Pumpen der aktiven Schicht 3 sind auf eine dem Substrat 7 gegenüber liegende Oberfläche der Halbleiterschichtenfolge des Halbleiterlasers mehrere Kontaktflächen 8a, 8b, 8c aufgebracht, durch die ein elektrischer Strom in Teilbereiche der aktiven Schicht 3 eingeprägt werden kann. Als zweiter elektrischer Kontakt kann beispielsweise das Substrat 7 fungieren, das in diesem Fall elektrisch leitend ist.

Die Mittelpunkte der den Seitenfacetten 9 des Halbleiterlasers benachbarten Kontaktflächen 8a, 8c sind vorzugsweise jeweils um eine Transferlänge L_{C} von der jeweiligen Seitenfacette 9 beabstandet. Auf diese Weise wird erreicht, dass durch elektrisches Pumpen der aktiven Schicht 3 ein Intensitätsmaximum in der ersten Wellenleiterschicht 1 in einem Abstand von der Seitenfacette 9 des Halbleiterlasers erzeugt wird, der gleich der Transferlänge L_{C} ist. Die in diesen Bereichen erzeugte Laserstrahlung kann bei der Ausbreitung in Richtung der Seitenfacetten 9 maximal in die zweite Wellenleiterschicht 2 überkoppeln, so dass an der Seitenfacette 9 ein Intensitätsmaximum in der zweiten Wellenleiterschicht 2 und ein korrespondierendes Intensitätsminimum in der ersten Wellenleiterschicht 1 vorliegt. Diese Anordnung der Kontaktflächen 8a, 8b, 8c hat weiterhin zur Folge, dass die als gestrichelte Linie dargestellte stehende Welle 13a, welche Intensitätsmaxima in der ersten Wellenleiterschicht 1 im Bereich der Seitenfacetten 9 aufweisen würde, nicht durch elektrisches Pumpen angeregt wird. Die Mittelpunkte der Kontaktflächen 8a, 8b, 8c sind untereinander jeweils um die zweifache Transferlänge L_{C} beabstandet, um die benachbarten Intensitätsmaxima innerhalb der ersten Wellenleiterschicht anzuregen.

Das in Figur 3 dargestellte Ausführungsbeispiel der Erfindung hat insbesondere den Vorteil, dass eine lokale Veränderung des effektiven Brechungsindex in einer der Wellenleiterschichten nicht erforderlich ist.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Kantenemittierender Halbleiterlaser mit einer Laserstrahlung (13) erzeugenden aktiven Schicht (3), die in eine erste Wellenleiterschicht (1) eingebettet ist, wobei
- die erste Wellenleiterschicht (1) zwischen einer ersten Mantelschicht (4) und einer zweiten Mantelschicht (5) angeordnet ist und in lateraler Richtung an Seitenfacetten (9), welche einen Resonator des Halbleiterlasers ausbilden, angrenzt,
- an die zweite Mantelschicht (5) eine zweite Wellenleiterschicht (2) angrenzt, in die keine aktive Schicht eingebettet ist, und
- an einer von der ersten Wellenleiterschicht (1) abgewandten Seite der zweiten Wellenleiterschicht (2) eine dritte Mantelschicht (6) angeordnet ist, und die erste Wellenleiterschicht (1) und die zweite Wellenleiterschicht (2) in ihrer gesamten lateralen Ausdehnung zwischen den Seitenfacetten (9) optisch aneinander gekoppelt sind,
**dadurch gekennzeichnet, dass**
- mehrere Kontaktflächen (8a, 8b, 8c) in periodischen Abständen auf Teilbereiche des Halbleiterlasers aufgebracht sind, die zum elektrischen Pumpen der Laserstrahlung erzeugenden aktiven Schicht (3) dienen,
- die periodischen Abstände der Kontaktflächen (8a, 8b, 8c) jeweils gleich der zweifachen Transferlänge (L_{C}) sind, wobei die Transferlänge (L_{C}) der Abstand zwischen einem Intensitätsmaximum der Laserstrahlung und einem benachbarten Intensitätsminimum der Laserstrahlung innerhalb einer der Wellenleiterschichten (1, 2) ist, und
- die Mittelpunkte der den Seitenfacetten (9) des Halbleiterlasers benachbarten Kontaktflächen (8a, 8c) jeweils um eine Transferlänge von der jeweiligen Seitenfacette (9) beabstandet sind.

2. Kantenemittierender Halbleiterlaser nach Anspruch 1,
**dadurch gekennzeichnet, dass**
die zweite Wellenleiterschicht (2) derart an die erste Wellenleiterschicht (1) optisch gekoppelt ist, dass sich an den Seitenfacetten (9) des Halbleiterlasers zumindest ein Teil der in der aktiven Schicht (3) erzeugten Laserstrahlung (13) in der zweiten Wellenleiterschicht (2) ausbreitet.

3. Kantenemittierender Halbleiterlaser nach Anspruch 2,
**dadurch gekennzeichnet, dass**
die zweite Wellenleiterschicht (2) derart an die erste Wellenleiterschicht (1) optisch gekoppelt ist, dass die sich die in der ersten Wellenleiterschicht (1) ausbreitende Laserstrahlung an den Seitenfacetten (9) des Halbleiterlasers ein Intensitätsminimum aufweist.

4. Kantenemittierender Halbleiterlaser nach einem der Ansprüche 1 bis 3,
**dadurch gekennzeichnet, dass**
die in der aktiven Schicht (3) erzeugte Laserstrahlung (13) eine stehende Welle ausbildet, die in lateraler Richtung in periodischen Abständen jeweils Intensitätsmaxima in der ersten Wellenleiterschicht (1) und korrespondierende Intensitätsminima in der zweiten Wellenleiterschicht (2) sowie Intensitätsminima in der ersten Wellenleiterschicht (1) und korrespondierende Intensitätsmaxima in der zweiten Wellenleiterschicht (2) aufweist.

5. Kantenemittierender Halbleiterlaser nach Anspruch 4,
**dadurch gekennzeichnet, dass**
die stehende Welle an den Seitenfacetten (9) des Halbleiterlasers jeweils ein Intensitätsminimum in der ersten Wellenleiterschicht (1) aufweist.

## Claims

1. Edge emitting semiconductor laser comprising an active layer (3) that generates laser radiation (13) and is embedded into a first waveguide layer (1), wherein
- the first waveguide layer (1) is arranged between a first cladding layer (4) and a second cladding layer (5) and adjoins side facets (9), which form a resonator of the semiconductor laser, in a lateral direction,
- a second waveguide layer (2), into which no active layer is embedded, adjoins the second cladding layer (5), and
- a third cladding layer (6) is arranged at a side of the second waveguide layer (2) that is remote from the first waveguide layer (1), and
the first waveguide layer (1) and the second waveguide layer (2) are optically coupled to one another in their entire lateral extent between the side facets (9),
**characterized in that**
- a plurality of contact areas (8a, 8b, 8c) are applied to partial regions of the semiconductor laser at periodic distances, which contact areas serve for electrically pumping the active layer (3) that generates laser radiation,
- the periodic distances between the contact areas (8a, 8b, 8c) are in each case equal to twice the transfer length (Lc), wherein the transfer length (Lc) is the distance between an intensity maximum of the laser radiation and an adjacent intensity minimum of the laser radiation within one of the waveguide layers (1, 2), and
- the midpoints of the contact areas (8a, 8c) which are adjacent to the side facets (9) of the semiconductor laser are in each case spaced apart from the respective side facet (9) by one transfer length.

2. Edge emitting semiconductor laser according to Claim 1,
**characterized in that**
the second waveguide layer (2) is optically coupled to the first waveguide layer (1) in such a way that, at the side facets (9) of the semiconductor laser, at least part of the laser radiation (13) generated in the active layer (3) propagates in the second waveguide layer (2).

3. Edge emitting semiconductor laser according to Claim 2,
**characterized in that**
the second waveguide layer (2) is optically coupled to the first waveguide layer (1) in such a way that the laser radiation propagating in the first waveguide layer (1) has an intensity minimum at the side facets (9) of the semiconductor laser.

4. Edge emitting semiconductor laser according to any of Claims 1 to 3,
**characterized in that**
the laser radiation (13) generated in the active layer (3) forms a standing wave having in a lateral direction at periodic intervals in each case intensity maxima in the first waveguide layer (1) and corresponding intensity minima in the second waveguide layer (2) and intensity minima in the first waveguide layer (1) and corresponding intensity maxima in the second waveguide layer (2).

5. Edge emitting semiconductor laser according to Claim 4,
**characterized in that**
the standing wave, at the side facets (9) of the semiconductor laser, has in each case an intensity minimum in the first waveguide layer (1).

## Revendications

1. Laser à semi-conducteur à émission par le bord comportant une couche active (3) générant un rayonnement laser (13), laquelle couche active est incorporée à une première couche de guide d'ondes (1), dans lequel
- la première couche de guide d'ondes (1) est disposée entre une première couche de revêtement (4) et une deuxième couche de revêtement (5) et est adjacente, dans la direction latérale, à des facettes latérales (9) qui forment un résonateur du laser à semi-conducteur,
- une deuxième couche de guide d'ondes (2) dans laquelle aucune couche active n'est incorporée est adjacente à la deuxième couche de revêtement (5), et
- une troisième couche de revêtement (6) est disposée sur une face de la deuxième couche de revêtement (2) qui est tournée à l'opposé de la première couche de guide d'ondes (1), et la première couche de guide d'ondes (1) et la deuxième couche de guide d'ondes (2) sont couplées optiquement l'une à l'autre sur la totalité de leur extension latérale entre les facettes latérales (9),
**caractérisé en ce que**
- plusieurs surfaces de contact (8a, 8b, 8c) sont déposées à des distances périodiques sur des régions partielles du laser à semi-conducteur, lesquelles surfaces de contact sont utilisées pour la pompage électrique de la couche active (3) générant le rayonnement laser,
- les distances périodiques des surfaces de contact (8a, 8b, 8c) sont respectivement identiques au double de la longueur de transfert (L_{C}), dans lequel la longueur de transfert (L_{C}) est la distance entre un maximum d'intensité du rayonnement laser et un minimum d'intensité voisin du rayonnement laser à l'intérieur de l'une des couches de guide d'ondes (1, 2), et
- les centres des surfaces de contact (8a, 8c) voisines des facettes latérales (9) du laser à semi-conducteur sont respectivement espacés d'une longueur de transfert de la facette latérale (9) respective.

2. Laser à semi-conducteur à émission par le bord selon la revendication 1,
**caractérisé en ce que** la deuxième couche de guide d'ondes (2) est couplée optiquement à la première couche de guide d'ondes (1) de manière à ce qu'au moins une partie du rayonnement (13) généré dans la couche active (3) se propage sur les facettes latérales (9) du laser à semi-conducteur dans la deuxième couche de guide d'ondes (2).

3. Laser à semi-conducteur à émission par le bord selon la revendication 2,
**caractérisé en ce que** la deuxième couche de guide d'ondes (2) est couplée optiquement à la première couche de guide d'ondes (1) de manière à ce que le rayonnement laser se propageant dans la première couche de guide d'ondes (1) présente un minimum d'intensité sur les facettes latérales (9) du laser à semi-conducteur.

4. Laser à semi-conducteur à émission par le bord selon l'une quelconque des revendications 1 à 3,
**caractérisé en ce que** le rayonnement (13) généré dans la couche active (3) forme une onde stationnaire qui présente, dans la direction latérale et à des distances périodiques, des maxima d'intensité respectifs dans la première couche de guide d'ondes (1) et des minima d'intensité correspondants dans la deuxième couche de guide d'ondes (2) ainsi que des minima d'intensité dans la première couche de guide d'ondes (1) et des maxima d'intensité correspondants dans la deuxième couche de guide d'ondes (2).

5. Laser à semi-conducteur à émission par le bord selon la revendication 4,
**caractérisé en ce que** l'onde stationnaire présente sur les facettes latérales (9) du laser à semi-conducteur,
un minimum d'intensité respectif dans la première couche de guide d'ondes (1).
